(19) **Europäisches Patentamt European Patent Office Office européen des brevets**

(11) **EP 3 343 605 B1**

(12) **EUROPEAN PATENT SPECIFICATION**

(45) Date of publication and mention
of the grant of the patent:
**12.06.2024  Bulletin 2024/24**

(21) Application number: **16838811.4**

(22) Date of filing: **23.08.2016**

(51) International Patent Classification (IPC):
**H01L 23/36** *(2006.01)*      **H05K 7/20** *(2006.01)*

(52) Cooperative Patent Classification (CPC):
**H01L 23/3737; B32B 3/14; B32B 3/18;
B32B 27/08; B32B 27/18; B32B 27/304;
B32B 27/322; H05K 7/20481; H05K 7/20963;**
B32B 2250/24; B32B 2260/021; B32B 2260/046;
B32B 2262/106; B32B 2264/108; B32B 2305/30;

(Cont.)

(86) International application number:
**PCT/JP2016/003842**

(87) International publication number:
**WO 2017/033461 (02.03.2017 Gazette 2017/09)**

(54) **HEAT CONDUCTIVE SHEET AND METHOD OF MANUFACTURING THE SAME**

WÄRMELEITFÄHIGE FOLIE UND VERFAHREN ZU DEREN HERSTELLUNG

FEUILLE CONDUCTRICE DE CHALEUR ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.08.2015  JP 2015164893**

(43) Date of publication of application:
**04.07.2018  Bulletin 2018/27**

(73) Proprietor: **Zeon Corporation
Tokyo 100-8246 (JP)**

(72) Inventors:
• **ITO, Toyokazu
Tokyo 100-8246 (JP)**
• **KUMAMOTO, Takurou
Tokyo 100-8246 (JP)**

• **MURAKAMI, Yasuyuki
Tokyo 100-8246 (JP)**

(74) Representative: **Maiwald GmbH
Elisenhof
Elisenstraße 3
80335 München (DE)**

(56) References cited:
**EP-A1- 2 291 066        EP-A1- 2 583 993
JP-A- 2009 088 164      JP-A- 2013 058 701
JP-A- 2013 256 578      US-A1- 2008 019 097
US-A1- 2014 293 626**

EP 3 343 605 B1

(52) Cooperative Patent Classification (CPC): (Cont.)
B32B 2307/302; B32B 2307/538; B32B 2307/732;
B32B 2457/00

**Description**

TECHNICAL FIELD

The present disclosure relates to methods of manufacturing heat conductive sheets containing a resin and a carbon material.

BACKGROUND

In recent years, electronic parts such as plasma display panels (PDPs) and integrated circuit (IC) chips generate more heat along with their increasing performance. This has led to the necessity of taking measures to prevent function failure due to temperature rises in the electronic parts of electronic devices.

General measures to prevent function failure due to temperature rise involve attaching a heat radiator such as a metallic heat sink, radiation plate or radiation fin to a heat source such as an electronic part to facilitate heat dissipation. When a heat radiator is used, the heat radiator and the heat source are closely attached to each other via a sheet member having high heat conductivity (heat conductive sheet) in order to efficiently transfer heat from the heat source to the heat radiator. Hence, heat conductive sheets sandwiched between a heat source and a heat radiator during use are required to have high flexibility, as well as high heat conductivity.

To that end, for example, PTL 1 discloses a technique of obtaining a heat conductive sheet containing heat conductive filler materials oriented in sheet thickness direction. This technique involves preparing primary sheet(s) in which heat conductive filler materials like graphite particles are oriented in sheet main surface direction (i.e., a direction perpendicular to thickness direction); forming a shaped article for example by laminating the primary sheets on top of each other or rolling the primary sheet; and slicing the obtained shaped article in a given direction. Due to the inclusion of resin, the heat conductive sheet of PTL 1 can exert high flexibility. Further, this heat conductive sheet has superior heat conductivity in thickness direction because the heat conductive filler materials are oriented in sheet thickness direction.

PTL 2 relates to a thermal conductive sheet obtained by preparing a resin layer; laminating a particle-containing monomer mixture layer which contains a monomer to be absorbed in the resin layer and a thermal conductive particle on one side surface of the resin layer; localizing the thermal conductive particle at one surface side by allowing the monomer to be absorbed in the resin layer; thereafter, reacting the monomer to be cured so as to fabricate a particle-localized sheet; laminating a plurality of the particle-localized sheets so as to allow one surface thereof to be in contact with the other surface thereof to fabricate a particle-localized sheet laminate; and then, cutting the particle-localized sheet laminate into a sheet shape along a laminating direction of each of the particle-localized sheets.

CITATION LIST

Patent Literature

PTL 1: WO2008/053843 (US 2014/0293626 A1)
PTL 2: JP 2013 058701 A (US 2013/0065016 A1)

SUMMARY

(Technical Problem)

PTL 1 is mainly focused on improving heat conductivity and flexibility of conventional heat conductive sheets. Specifically, PTL 1 achieved good heat conductivity and flexibility by the use of a resin with specific properties and by setting the average particle diameter of the heat conductive filler material within the heat conductive sheet to 200 $\mu$m or more.

However, extensive studies conducted by the inventors of the present disclosure revealed that while heat conductive filler materials with average particle diameters of 200 $\mu$m or more allow heat conductive sheets to have improved heat conductivity due to their large particle diameters which contribute to relatively less thermal resistance at the interface between the resin and heat conductive filler material, such heat conductive filler materials present risks of reducing the strength of the primary sheet. Reduced primary sheet strength renders difficult the lamination of primary sheets or slicing of the laminate of the primary sheets during manufacture of a heat conductive sheet, resulting in risks of significant reductions in the productivity of heat conductive sheet manufacturing.

An object of the present disclosure is to provide a method of manufacturing a heat conductive sheet, as defined by invention according to claim 1, which method may allow for efficient manufacture of heat conductive sheets with sufficiently high levels of heat conductivity.

(Solution to Problem)

The inventors made extensive studies to achieve the foregoing object. As a result, the inventors discovered that the use of a composition containing a resin and a carbon material with a specific particle diameter for the manufacture of a heat conductive sheet can increase the strength of a primary sheet whereby a heat conductive sheet can be manufactured with high efficiency, and further that the heat conductive sheet formed using such a primary sheet is superior in heat conductivity. The present disclosure was completed based on these discoveries.

Specifically, the present disclosure is aimed at advantageously solving the foregoing problem, and discloses a method of manufacturing a heat conductive sheet comprising strips joined together side-by-side, each strip comprising a resin and a carbon material having a number-based modal diameter of 5 $\mu$m to 50 $\mu$m and comprising a particulate carbon material, wherein the heat conductive sheet has heat conductivity in thickness direction of 40 W/m·k or more, the method comprising: mixing a particulate carbon material having a first particle diameter and a resin to provide a composition; shaping the composition into a sheet by pressure application to provide a pre-heat conductive sheet containing the particulate carbon material having a second particle diameter and the resin; obtaining a laminate either by laminating the pre-heat conductive sheets on top of each other or by folding or rolling the pre-heat conductive sheet; and slicing the laminate at an angle of 45° or less relative to the lamination direction to provide a heat conductive sheet which comprises strips joined together side-by-side, each strip comprising the carbon material having the second particle diameter and the resin, wherein the particulate carbon material is subjected to a particle size change as a result of being disintegrated in the pre-heat conductive sheet forming step, such that the second particle diameter is a number-based modal diameter which is 5 $\mu$m to 50 $\mu$m and is smaller than the first particle diameter. A heat conductive sheet which can be manufactured by the disclosed method of manufacturing a heat conductive sheet has sufficiently high levels of heat conductivity as well as can be manufactured with high efficiency.

As used herein, the "number-based modal diameter" of a carbon material refers to a particle diameter corresponding to the maximum in a particle size distribution curve of the carbon material (a plot of carbon material count vs. particle diameter) as measured for example for a certain suspension containing the carbon material using a laser diffraction/scattering particle size analyzer.

"Heat conductivity" herein is calculated using the following Equation (I):

$$\text{Heat conductivity } \lambda \text{ (W/m·K)} = \alpha \times Cp \times \rho \; ... \; (I)$$

where $\alpha$ is thermal diffusivity (m$^2$/s), Cp is specific heat at constant pressure (J/g·K) and $\rho$ is density (g/m$^3$) of the heat conductive sheet. "Thermal diffusivity" can be measured using a thermal analyzer, "specific heat at constant pressure" can be measured using a differential scanning calorimeter, and "density" can be measured using an automatic specific gravity meter.

In the disclosed method of manufacturing a heat conductive sheet, the carbon material comprises a particulate carbon material. A correspondingly manufactured heat conductive sheet can achieve better heat conductivity and productivity at the same time.

By "particulate" carbon material it is meant herein that the aspect ratio, defined as the ratio of major axis to minor axis, of the carbon material is 1 to 10.

It is also preferred in the disclosed method of manufacturing a heat conductive sheet that the carbon material further comprises a fibrous carbon material. A correspondingly manufactured heat conductive sheet has higher heat conductivity and higher strength. Further, the particulate carbon material is less likely to fall off from such a heat conductive sheet.

It is also preferred in the disclosed method of manufacturing a heat conductive sheet that at least one main surface of the disclosed heat conductive sheet has an arithmetic mean roughness Ra of 15 $\mu$m or less. Such a heat conductive sheet has smooth surface and, when sandwiched between articles to be attached such as a heat source and a heat radiator, can increase adhesion between itself and the heat source or radiator thereby facilitating heat conduction between the heat source and heat radiator.

The arithmetic mean roughness Ra herein can be measured with a surface roughness meter (SJ-201, Mitutoyo Corporation).

It is also preferred in the disclosed method of manufacturing a heat conductive sheet that the resin is a fluororesin. The use of fluororesin increases the flexibility of the heat conductive sheet, so that adhesion between the heat conductive sheet and an article to be attached to the heat conductive sheet can be increased.

Further disclosed herein and not forming part of the invention is a heat conductive sheet comprising strips joined together side-by-side, each strip comprising a resin and a carbon material having a number-based modal diameter of 5 μm to 50 μm and comprising a particulate carbon material, wherein the heat conductive sheet has heat conductivity in thickness direction of 40 W/m·k or more.

The disclosed method of manufacturing a heat conductive sheet is used to manufacture the above-described heat conductive sheet having a particulate carbon material, and includes the steps of: mixing a particulate carbon material having a first particle diameter and a resin to provide a composition; shaping the composition into a sheet by pressure application to provide a pre-heat conductive sheet containing the particulate carbon material having a second particle diameter and the resin; obtaining a laminate either by laminating the pre-heat conductive sheets on top of each other or by folding or rolling the pre-heat conductive sheet; and slicing the laminate at an angle of 45° or less relative to the lamination direction to provide a heat conductive sheet which comprises strips joined together side-by-side, each strip comprising the carbon material having the second particle diameter and the resin, wherein the particulate carbon material is subjected to a particle size change as a result of being disintegrated in the pre-heat conductive sheet forming step, such that the second particle diameter is a number-based modal diameter which is 5 μm to 50 μm and is smaller than the first particle diameter.

With such a manufacturing method, it is possible to more efficiently manufacture a heat conductive sheet having superior heat conductivity.

(Advantageous Effect)

According to the present disclosure, it is possible to provide a heat conductive sheet that achieves sufficiently high levels of heat conductivity and productivity at the same time.

DETAILED DESCRIPTION

Embodiments of the present disclosure will now be described in detail. The disclosed, however not forming part of the invention, heat conductive sheet can, for example, be provided between a heat generator and a heat radiator when attaching the heat radiator to the heat generator. Specifically, the disclosed heat conductive sheet can constitute a heat dissipation device in combination with a heat radiator such as a heat sink, radiation plate or radiation fin. The disclosed heat conductive sheet can be manufactured for example by the disclosed method of manufacturing a heat conductive sheet.

The disclosed heat conductive sheet is superior in heat conductivity having heat conductivity in thickness direction of as high as 40 W/m·k or more. Further, the strips that constitute the disclosed heat conductive sheet comprise a resin, a carbon material having a number-based modal diameter of 5 μm to 50 μm and comprising a particulate carbon material, and optionally additives. By including a carbon material having a number-based modal diameter of 5 μm to 50 μm, the strips that constitute the heat conductive sheet have high strength and are easy to handle when joining them together side-by-side during manufacture of the heat conductive sheet, so that the disclosed heat conductive sheet can be manufactured with high efficiency.

<Resin>

Any of the resins known in the art which may be used for forming a heat conductive sheet can be used. Specific examples of usable resins are thermoplastic or thermosetting resins. As used herein, "resin" encompasses rubbers and elastomers. Thermoplastic resins and thermosetting resins may be used in combination.

[Thermoplastic Resins]

Examples of thermoplastic resins include acrylic resins such as poly(2-ethylhexyl acrylate), copolymers of acrylic acid and 2-ethylhexyl acrylate, polymethacrylic acids or esters thereof, and polyacrylic acids or esters thereof; silicone resins; fluororesins such as polytetrafluoroethylene, tetrafluoroethylene-perfluoroalkyl vinyl ether copolymers, tetrafluoroethylene-hexafluoropropylene copolymers, tetrafluoroethylene-ethylene copolymers, polyvinylidene fluoride, polychlorotrifluoroethylene, ethylene-chlorofluoroethylene copolymers, tetrafluoroethylene-perfluorodioxole copolymers, polyvinyl fluoride, tetrafluoroethylene-propylene copolymers, vinylidene fluoride-tetrafluoroethylene-hexafluoropropylene copolymers, acrylic modified products of polytetrafluoroethylene, ester modified products of polytetrafluoroethylene, epoxy modified products of polytetrafluoroethylene, and silane-modified products of polytetrafluoroethylene; polyethylenes; polypropylenes; ethylenepropylene copolymers; polymethylpentenes; polyvinyl chlorides; polyvinylidene chlorides; polyvinyl acetates; ethylene-vinyl acetate copolymers; polyvinyl alcohols; polyacetals; polyethylene terephthalates; polybutylene terephthalates; polyethylene naphthalates; polystyrenes; polyacrylonitriles; styrene-acrylonitrile copolymers; acrylonitrile-butadienestyrene copolymers (ABS resins); styrene-butadiene block copolymers or hydrogenated products thereof; styrene-isoprene block copolymers or hydrogenated products thereof; polyphenylene ethers; modified polyphenylene ethers; aliphatic polyamides; aromatic polyamides; polyamideimides; polycarbonates; polyphenylene sulfides; polysulfones; polyether sulfones; polyether nitriles; polyether ketones; polyketones; polyurethanes; liquid crystal polymers; and ionomers. These thermoplastic resins may be used alone or in combination.

[Thermosetting Resins]

Examples of thermosetting resins include natural rubbers; butadiene rubbers; isoprene rubbers; nitrile rubbers; hydrogenated nitrile rubbers; chloroprene rubbers; ethylene propylene rubbers; chlorinated polyethylenes; chlorosulfonated polyethylenes; butyl rubbers; halogenated butyl rubbers; polyisobutylene rubbers; epoxy resins; polyimide resins; bismaleimide resins; benzocyclobutene resins; phenol resins; unsaturated polyesters; diallyl phthalate resins; polyimide silicone resins; polyurethanes; thermosetting polyphenylene ethers; and thermosetting modified polyphenylene ethers. These thermosetting resins may be used alone or in combination.

Of these resins mentioned above, preferred for the heat conductive sheet are fluororesins because fluororesins can increase the flexibility of the heat conductive sheet so that adhesion between the heat conductive sheet and an article to be attached to the heat conductive sheet can be increased.

<Carbon Material>

The carbon material included in the disclosed heat conductive sheet has a number-based modal diameter of 5 $\mu$m to 50 $\mu$m, and comprises a particulate carbon material.

[Modal Diameter of Carbon Material]

The carbon material included in the disclosed heat conductive sheet needs to have a number-based modal diameter of 5 $\mu$m to 50 $\mu$m. Preferably, the carbon material has a number-based modal diameter of 40 $\mu$m or less, more preferably 30 $\mu$m or less, and even more preferably 20 $\mu$m or less. Heretofore, it has been common to use carbon materials with relatively large particle diameters ($\geq$200 $\mu$m average particle diameter) to reduce the interface resistance between particles to allow heat conductive sheets to have increased heat conductivity. However, increased modal particle diameters of carbon materials tend to reduce the strength of strips constituting a heat conductive sheet, which contain a resin and a carbon material. Thus, heretofore, there was a trade-off relationship between improving the heat conductivity of the heat conductive sheet and improving the strip strength. The inventors have discovered that by setting the modal diameter of the carbon material included in the strips constituting the heat conductive sheet to fall within the above specified range, it would be possible to achieve high levels of heat conductivity of the heat conductive sheet and strip strength at the same time. Specifically, in the present disclosure, by setting the modal diameter of the carbon material included in the strips constituting the heat conductive sheet to 5 $\mu$m or more, the heat conductivity of the heat conductive sheet can be improved. Further, in the present disclosure, by setting the modal diameter of the carbon material included in the strips constituting the heat conductive sheet to 50 $\mu$m or less, it is possible to avoid significant reductions in the productivity of heat conductive sheet manufacturing due to strip strength reductions attributed to the size of carbon material, as well as to improve the elongation of the strips. In other words, when the number-based modal diameter of the carbon material to be included exceeds 50 $\mu$m, the productivity of heat conductive sheet manufacturing cannot be sufficiently increased.

The modal diameter of the carbon material included in the heat conductive sheet can be changed as desired by regulating the manufacturing conditions described later.

[Particulate Carbon Material]

Any particulate carbon material can be used. Examples of usable particulate carbon materials include graphite such as artificial graphite, flake graphite, flaked graphite, natural graphite, acid-treated graphite, expandable graphite, and expanded graphite; carbon black; and graphene. These particulate carbon materials may be used alone or in combination.

Of these particulate carbon materials, preferred is expanded graphite for its capability of enhancing the heat conductivity of the heat conductive sheet.

The particulate carbon material included in the disclosed heat conductive sheet generally has an aspect ratio (major axis/minor axis) of 1 to 10, preferably 1 to 5. The "aspect ratio" herein can be found by measuring maximum diameters (major diameters) and diameters in a direction perpendicular to the maximum diameter (minor diameters) for randomly-selected 50 particulate carbon materials observed in a vertical (thickness direction) cross-sectional scanning electron micrograph (SEM) of the heat conductive sheet, and calculating the average of ratios of the major diameter to the minor diameter (major diameter/minor diameter).

-Expanded Graphite-

Expanded graphite which may be suitably used as the particulate carbon material can be obtained for example by thermal expansion of expandable graphite which has been obtained by chemical treatment of graphite such as flake graphite with sulfuric acid or the like, followed by micronization. Examples of expanded graphite to be blended in the disclosed heat conductive sheet include products available from Ito Graphite Co., Ltd. under the trade names EC1500, EC1000, EC500, EC300, EC100, and EC50.

-Graphene-

As described above, graphene can also be employed as the particulate carbon material. Graphene herein refers to a structure in which carbon atoms are arranged in a honeycomb pattern in 1 to 5 layers. Graphene that may be used as the particulate carbon material may have any shape so long as it is in particulate form. "Flaked graphite" described above has a structure in which more than 5 layers of graphene are stacked. Graphene may also be oxidized (oxidized graphene), have a functional group such as a hydroxyl group, or have a metal supported thereon.
Graphene, oxidized graphene, functional group-containing grapheme, and metal-supporting graphene may be subjected to various types of treatment as necessary. Examples of such treatment include reduction treatment using hydrazine or the like, microwave treatment, ozone treatment, plasma treatment, and oxygen plasma treatment. These treatments may be carried out alone or in combination.

[Modal Diameter of Particulate Carbon Material as Material]

The size of the particulate carbon material as a material to be blended during manufacture of the disclosed heat conductive sheet only needs to be such that the number-based modal diameter is 5 $\mu$m or more. The "number-based modal diameter" of the particulate carbon material as a material to be blended during manufacture of the disclosed heat conductive sheet can be measured similarly to that of the carbon material blended in the heat conductive sheet, e.g., with a laser diffraction/scattering particle size analyzer. Specifically, the particulate carbon material used as a material used to form the heat conductive sheet is dispersed in methyl ethyl ketone to prepare a suspension and then the particle diameters of the particulate carbon material in the suspension are measured. The particle diameter corresponding to the maximum in a particle size distribution curve, which is a plot of carbon material count vs. measured particle diameter, is found as the number-based modal diameter of the particulate carbon material as a material.

[Particulate Carbon Material Content]

The disclosed heat conductive sheet preferably contains the particulate carbon material at an amount of 30% by mass or more, more preferably 40% by mass or more, even more preferably 50% by mass or more, but preferably 90% by mass or less, more preferably 80% by mass or less, even more preferably 75% by mass or less. When the heat conductive sheet contains the particulate carbon material at an amount of 30% by mass to 90% by mass, it is possible to sufficiently increase the productivity of heat conductive sheet manufacturing and the heat conductivity of the heat conductive sheet in a well-balanced manner. When the heat conductive sheet contains the particulate carbon material at an amount of 90% or less, it is possible to sufficiently prevent falling of the particulate carbon material. Of note, it is necessary to blend large amounts of the particulate carbon material to achieve high heat conductivity, but there is a tendency that increased blending amounts of particulate carbon material reduces the strength of strips constituting the heat conductive sheet and therefore leads to poor productivity of heat conductive sheet manufacturing. In contrast, in the present disclosure, it is possible to sufficiently increase the productivity of heat conductive sheet manufacturing and the heat conductivity of the heat conductive sheet in a well-balanced manner by setting the particulate carbon material content to fall within the above-described range.

[Fibrous Carbon Material]

The carbon material included in the disclosed heat conductive sheet may further comprise a fibrous carbon material. Any fibrous carbon material can be used. Examples of usable fibrous carbon materials include carbon nanotubes, vapor grown carbon fibers, carbon fibers obtained by carbonization of organic fibers, chopped products thereof, and graphene. These fibrous carbon materials may be used alone or in combination. When graphene is included in the heat conductive sheet as the fibrous carbon material, any type of graphene can be used so long as it has a fibrous shape; it is possible to use graphene having the same properties as the graphene which may be included in the heat conductive sheet as the particulate carbon material.

When the fibrous carbon material is included in the disclosed heat conductive sheet, it is possible to enhance the heat conductivity of the heat conductive sheet and the strength of the strips constituting the heat conductive sheet, as well as to efficiently limit falling of the particulate carbon material from the heat conductive sheet. A possible, but still uncertain reason that blending of the fibrous carbon material prevents falling of the particulate carbon material would be that the fibrous carbon material forms a three-dimensional structure whereby separation of the particulate carbon material is prevented while increasing heat conductivity and strength.

Of these fibrous carbon materials described above, preferred are fibrous carbon nanostructures such as carbon nanotubes, with fibrous carbon nanostructures including carbon nanotubes being more preferred. The use of fibrous carbon nanostructures such as carbon nanotubes allows for further increases in the heat conductivity of the disclosed heat conductive sheet and in the strength of strips constituting the heat conductive sheet.

[Fibrous Carbon Nanostructures including Carbon Nanotubes]

The fibrous carbon nanostructures including carbon nanotubes, which may be suitably used as the fibrous carbon material, may be composed solely of carbon nanotubes (hereinafter occasionally referred to as "CNTs") or may be a mixture of CNTs and fibrous carbon nanostructures other than CNTs.

For example, the fibrous carbon nanostructures including CNTs may include non-cylindrical carbon nanostructures. Specifically, the fibrous carbon nanostructures including CNTs may include single- or multi-walled flattened cylindrical carbon nanostructures having over the entire length a "tape portion" where inner walls are in close proximity to each other or bonded together (hereinafter such carbon nanostructures are occasionally referred to as "graphene nanotapes (GNTs)").

GNT is presumed to be a substance having over the entire length a tape portion where inner walls are in close proximity to each other or bonded together since it has been synthesized, and having a network of 6-membered carbon rings in the form of flattened cylindrical shape. The GNT's flattened cylindrical structure and the presence of a tape portion where inner walls are in close proximity to each other or bonded together in the GNT can be confirmed for example as follows: GNT and fullerene (C60) are sealed into a quartz tube and subjected to heat treatment under reduced pressure (fullerene insertion treatment) to form a fullerene-inserted GNT, followed by observation under transmission electron microscopy (TEM) of the fullerene-inserted GNT to confirm the presence of part in the GNT where no fullerene is inserted (tape portion).

Any type of CNTs may be used for the fibrous carbon nanostructures, such as, for example, single-walled carbon nanotubes and/or multi-walled carbon nanotubes, with single- to up to 5-walled carbon nanotubes being preferred, and single-walled carbon nanotubes being more preferred. The use of single-walled carbon nanotubes allows for further increases in the heat conductivity of the disclosed heat conductive sheet as well as in the strength of the heat conductive sheet and strips constituting the heat conductive sheet, as compared to the case where multi-walled carbon nanotubes are used.

The fibrous carbon nanostructures including CNTs preferably have a BET specific surface area of 600 $m^2/g$ or more, more preferably 800 $m^2/g$ or more, but preferably 2,500 $m^2/g$ or less, more preferably 1,200 $m^2/g$ or less. Moreover, when the CNTs of the fibrous carbon nanostructures are mainly open CNTs, it is preferred that the BET specific surface area is 1,300 $m^2/g$ or more. BET specific surface area of 600 $m^2/g$ or more can sufficiently increase the heat conductivity and strength of the disclosed heat conductive sheet. BET specific surface area of 2,500 $m^2/g$ or less can limit aggregation of the fibrous carbon nanostructures to increase the dispersiveness of CNTs in the heat conductive sheet.

As used herein, "BET specific surface area" refers to a nitrogen adsorption specific surface area measured by the BET method.

The fibrous carbon nanostructures including CNTs having the properties described above can be efficiently produced for example by the super growth method (see WO2006/011655), wherein during synthesis of CNTs through chemical vapor deposition (CVD) by supplying a feedstock compound and a carrier gas onto a substrate having thereon a catalyst layer for carbon nanotube production, the catalytic activity of the catalyst layer is dramatically improved by providing a trace amount of an oxidizing agent (catalyst activating material) in the system. Hereinafter, carbon nanotubes obtained by the super growth method may also be referred to as "SGCNTs."

The fibrous carbon nanostructures including CNTs produced by the super growth method may be composed solely of SGCNTs or may include, in addition to SGCNTs, other carbon nanostructures such as non-cylindrical carbon nanostructures. Specifically, the fibrous carbon nanostructures including CNTs produced by the super growth method may include graphene nanotapes (GNTs) described above.

[Properties of Fibrous Carbon Material]

The fibrous carbon material which may be included in the heat conductive sheet preferably has an average fiber diameter of 1 nm or more, preferably 3 nm or more, but preferably 2 $\mu$m or less, more preferably 1 $\mu$m or less. When the average fiber diameter of the fibrous carbon material falls within this range, it is possible to further increase the heat conductivity of the heat conductive sheet, as well as the strength of the heat conductive sheet and strips constituting the heat conductive sheet. Further, when the average fiber diameter of the fibrous carbon material falls within this range, it is also possible to allow the strips constituting the heat conductive sheet to be well elongated. The aspect ratio of the fibrous carbon material preferably exceeds 10.

The "average fiber diameter" herein can be found by measuring fiber diameters for 50 randomly-selected fibrous carbon materials observed in a vertical (thickness direction) cross-sectional scanning electron micrograph (SEM) or transmission electron micrograph (TEM) of the heat conductive sheet, and calculating the number-average of the measured fiber diameters. In particular, for smaller fiber diameters, it is suitable to observe a similar cross section with a transmission electron microscope (TEM).

<Fibrous Carbon Material Content>

The heat conductive sheet preferably contains the fibrous carbon material at an amount of 0.05% by mass or more, more preferably 0.2% by mass or more, but preferably 5% by mass or less, more preferably 3% by mass or less. When the heat conductive sheet contains the fibrous carbon material at an amount of 0.05% by mass or more, it is possible to sufficiently increase the heat conductivity and strength of the heat conductive sheet, as well as to sufficiently prevent falling of the particulate carbon material. When the heat conductive sheet contains the fibrous carbon material at an amount of 5% by mass or less, it is possible to further increase the heat conductivity of the disclosed heat conductive sheet as well as to achieve high levels of strength and elongation of the strips constituting the heat conductive sheet at the same time by limiting rises in hardness (i.e., reductions in flexibility) of the heat conductive sheet due to blending of the fibrous carbon material.

<Additives>

The disclosed heat conductive sheet can be optionally blended with additives known in the art that may be used to form heat conductive sheets. Any additive may be blended into the heat conductive sheet. Examples of additives include plasticizers; flame retardants such as red phosphorus flame retardants and phosphate flame retardants; toughness improvers such as urethane acrylates; moisture absorbents such as calcium oxide and magnesium oxide; adhesion improvers such as silane coupling agents, titanium coupling agents, and acid anhydrides; wettability improvers such as nonionic surfactants and fluorine surfactants; and ion trapping agents such as inorganic ion exchangers.

Of these additives, the heat conductive sheet is preferably blended with phosphate flame retardants. Blending of phosphate flame retardants efficiently increases the flame retardancy of the heat conductive sheet.

<Properties of Heat Conductive Sheet>

[Heat Conductivity in Thickness Direction]

The disclosed heat conductive sheet needs to have heat conductivity in thickness direction at 25°C of 40 W/m·k or more. Heat conductivity in thickness direction of 40 W/m·k or more is high enough for the heat conductive sheet, when for example sandwiched between a heat source and a heat radiator, to efficiently transfer heat from the heat source to the heat radiator.

[Arithmetic Mean Roughness Ra]

It is also preferred that at least one of the main surfaces (i.e., surfaces perpendicular to thickness direction) of the disclosed heat conductive sheet has an arithmetic mean roughness Ra of 15 $\mu$m or less, more preferably 13 $\mu$m or less. By setting the arithmetic mean roughness Ra of at least one main surface of the disclosed heat conductive sheet to 15 $\mu$m or less, it is possible to increase its adhesion to an article to be attached. It is also preferred that both of the main surfaces of the disclosed heat conductive sheet meet the arithmetic mean roughness R range above. By setting the arithmetic mean roughness Ra of both of the main surfaces of the disclosed heat conductive sheet to 15 $\mu$m or less, it is possible to further increase its adhesion to an article to be attached.

[Thickness of Heat Conductive Sheet]

The heat conductive sheet preferably has a thickness of 0.1 mm to 10 mm.

(Method of Manufacturing Heat Conductive Sheet)

The heat conductive sheet described above can be manufactured by the claimed method of manufacturing a heat conductive sheet including the steps of: mixing a particulate carbon material having a first particle diameter and a resin to provide a composition, shaping the composition into a sheet by pressure application to provide pre-heat conductive sheet(s) containing the particulate carbon material having a second particle diameter and the resin (pre-heat conductive sheet forming step); obtaining a laminate either by laminating the pre-heat conductive sheets on top of each other or by folding or rolling the pre-heat conductive sheet (heat conductive sheet laminate forming step); and slicing the laminate at an angle of 45° or less relative to the lamination direction to provide a heat conductive sheet which comprises strips joined together side-by-side, each strip comprising the carbon material having the second particle diameter and the resin (slicing step), wherein the particulate carbon material is subjected to a particle size change as a result of being disintegrated in the pre-heat conductive sheet forming step, such that the second particle diameter is a number-based modal diameter which is 5 $\mu$m to 50 $\mu$m and is smaller than the first particle diameter.

<Pre-Heat Conductive Sheet Forming Step>

In the pre-heat conductive sheet forming step, a composition containing a resin and a carbon material and optionally an additive is shaped into a sheet by pressure application to provide a pre-heat conductive sheet.

[Composition Containing Resin and Carbon Material]

The composition containing a resin and a carbon material is prepared by mixing a resin, a carbon material and an optional additive under stirring. The resin, carbon material and additive can be the resin, particulate carbon material, fibrous carbon material and additive mentioned above which may be included in the disclosed heat conductive sheet. Of note, the particulate carbon material which is included in the disclosed heat conductive sheet is subjected to particle size change as a result of being disintegrated by the influence of mixing under stirring or other actions in the pre-heat conductive sheet forming step. That is, the pre-heat conductive sheet comprises a particulate carbon material having a second particle diameter that is smaller than a first particle diameter-a particle diameter of the particulate carbon material as a material which is blended during the manufacture of the heat conductive sheet. The second particle diameter is a number-based modal diameter which is 5 $\mu$m to 50 $\mu$m. Similarly, the first particle diameter is a number-based modal diameter.

It should be noted that when a cross-linked resin is used as the resin for the heat conductive sheet, a pre-conductive sheet may be formed using a composition containing a cross-linked resin, or may be formed using a composition containing a cross-linkable resin and a curing agent, after which the cross-linkable resin is cross-linked to introduce the cross-linked resin into the heat conductive sheet.

Mixing under stirring can be effected by any means, e.g., using a mixing device known in the art, such as kneader, roll, Henschel mixer, Hobart mixer, high-speed mixer, or twin screw kneader. Mixing under stirring may be effected in the presence of solvent such as ethyl acetate or methyl ethyl ketone. The conditions for mixing under stirring can be determined as desired based for example on the particle diameter of the carbon material as a material, the target particle diameter of the carbon material in the heat conductive sheet and the kind of resin used such that the carbon material in the heat conductive sheet has a number-based modal diameter of 5 $\mu$m to 50 $\mu$m. For example, the conditions for mixing under stirring can be set as appropriate with reference to Examples described later. The temperature during mixing under stirring can be 5°C to 150°C, for example.

-Shaping of Composition Containing Resin and Carbon Material-

The composition containing a resin and a carbon material as prepared in the manner described above can then be shaped into a sheet by pressure application, optionally after it has been defoamed and disintegrated. The modal diameter of the carbon material can be adjusted also upon disintegration. When solvent has been used during mixing, it is preferred to remove the solvent before shaping the composition into a sheet. For example, when defoaming is performed under vacuum, solvent can be removed at the same time as defoaming.

Any method can be used for shaping of the composition containing a resin and a carbon material as long as pressure is applied. The composition can be shaped into a sheet by shaping methods known in the art, such as pressing, rolling or extruding. In particular, it is preferred that the composition is shaped into a sheet by rolling, more preferably by passing the composition between rolls with the composition sandwiched between protection films. Any protection film can be used, e.g., releasable polyethylene terephthalte films with good releasability or sandblasted polyethylene terephthalate films can be used. Roll temperature can be from 5°C to 150°C.

When the fibrous carbon material is to be included in the composition, it is preferred to perform the treatment described below to improve the dispersibility of the fibrous carbon material. First of all, because fibrous carbon material is easy to aggregate and is less dispersive, it is not easily dispersed well in the composition when mixed as it is with other components such as resin. On the other hand, aggregation of the fibrous carbon material can be prevented when it is mixed with other components in a dispersion liquid in which the fibrous carbon material is dispersed in solvent (dispersing medium). In this case, however, large volumes of solvent are used after mixing for example to solidify the solids to prepare a composition, resulting in concern of requiring increased volumes of solvent for the preparation of a composition. To avoid this, when a fibrous carbon material is to be blended in a composition used for forming a pre-heat conductive sheet, it is preferred that the fibrous carbon material is mixed with other components in the form of an aggregate (readily dispersible aggregate) which is obtained by removing the solvent from a dispersion liquid of the fibrous carbon material dispersed in solvent (dispersing medium). Any dispersion liquid can be used to prepare such a readily dispersible aggregate; dispersion liquids can be used which are prepared by dispersing an aggregate of fibrous carbon material into solvent by dispersing methods known in the art. Specifically, the dispersion liquid can be one containing a fibrous carbon material, solvent, and optionally dispersion liquid additives such as dispersants.

The aggregate of fibrous carbon material obtained by removing the solvent from a dispersion liquid of the fibrous carbon material is a highly readily dispersible aggregate because it is composed of a fibrous carbon material once dispersed in solvent and is more dispersible than an aggregate of the fibrous carbon material before dispersed into solvent. Thus, when such a readily dispersible aggregate is mixed with other components, it is possible to allow the fibrous carbon material to be well dispersed in the composition efficiently without using large volumes of solvent. Namely, manufacture of the heat conductive sheet preferably includes the step of preparing a readily dispersible aggregate prior to the pre-heat conductive sheet forming step.

-Pre-Heat Conductive Sheet-

In the pre-heat conductive sheet obtained by shaping the composition into a sheet by pressure application, the carbon material is aligned mainly in the in-plane direction and this configuration is presumed to contribute to improved heat conductivity particularly in the in-plane direction. Further, when the composition comprises the fibrous carbon material, since the fibrous carbon material is also oriented in the pre-heat conductive sheet, it is presumed that the heat conductivity of the pre-heat conductive sheet is further improved.

The pre-heat conductive sheet can have any thickness, e.g., can have a thickness of 0.05 mm to 2 mm. From the perspective of enhancing the heat conductivity of the heat conductive sheet, the thickness of the pre-heat conductive sheet is preferably greater than 5 times to 5,000 times, more preferably not greater than 400 times the number-based modal particle diameter of the carbon material in the heat conductive sheet.

Further, the Ra value of the main surface of the pre-heat conductive sheet is preferably 10 $\mu$m to 15 $\mu$m. When the Ra value of the main surface of the pre-heat conductive sheet is within such a range, it is possible to increase adhesion between the pre-heat conductive sheets when they are laminated on top of each other, so that the smoothness of a heat conductive sheet obtained by slicing the laminate of heat conductive sheets can be further increased.

<Laminate Forming Step>

In the laminate forming step, a laminate is obtained either by laminating on top of each other pre-heat conductive sheets obtained in the pre-heat conductive sheet forming step, or by folding or rolling the pre-heat conductive sheet. Formation of a laminate by folding of the pre-heat conductive sheet can be accomplished by any means, e.g., a folding device can be used to fold the pre-heat conductive sheet at a constant width. Formation of a laminate by rolling of the pre-heat conductive sheet can be accomplished by any means, e.g., by rolling the pre-heat conductive sheet around an axis parallel to the longitudinal or lateral direction of the pre-heat conductive sheet.

In the laminate obtained in the laminate forming step, generally, the adhesive force between the surfaces of the pre-heat conductive sheets is sufficiently obtained by the pressure applied upon lamination, folding or rolling of the pre-heat conductive sheet(s). However, when the adhesive force is insufficient or when delamination needs to be sufficiently limited, the laminate forming step may be performed with the surface of the pre-heat conductive sheet being slightly dissolved with solvent, or with an adhesive being applied on the surface of the pre-heat conductive sheet or an adhesive layer being provided on the surface of the pre-heat conductive sheet.

Any solvent can be used to dissolve the surface of the pre-heat conductive sheet, and any solvent known in the art capable of dissolving the resin component included in the pre-heat conductive sheet can be used.

Any adhesive can be applied to the surface of the pre-heat conductive sheet, e.g., a commercially available adhesive or tacky resin can be used. Of them, preferred adhesives are resins having the same composition as the resin component included in the pre-heat conductive sheet. The thickness of the adhesive applied to the surface of the pre-heat conductive sheet can be 10 $\mu$m to 1,000 $\mu$m, for example.

Any adhesive layer can be provided on the surface of the pre-heat conductive sheet, e.g., a double-sided adhesive tape or the like can be used.

From the viewpoint of preventing delamination, it is preferred that the obtained laminate is pressed in the lamination direction at a pressure of 0.05 MPa to 1.0 MPa at 20°C to 100°C for 1 to 30 minutes.

When the fibrous carbon material has been added to the composition or expanded graphite has been used as the particulate carbon material, in a laminate obtained by laminating, folding or rolling pre-heat conductive sheet(s), it is presumed that the expanded graphite and the fibrous carbon material are aligned in a direction substantially perpendicular to the lamination direction.

[Slicing Step]

In the slicing step, the laminate obtained in the laminate forming step is sliced at an angle of 45° or less relative to the lamination direction to provide a heat conductive sheet formed of a sliced piece of the laminate. Any method can be used to slice the laminate, e.g., multi-blade method, laser processing method, water jet method, or knife processing method can be used, with the knife processing method being preferred because the thickness of the heat conductive sheet can be easily made uniform. The knife used in the knife processing method may have a single-edged, double-edged or asymmetric blade, but from the viewpoint of achieving thickness accuracy, a single-edged blade is preferred. Any cutting tool can be used to slice the laminate, e.g., a slicing member which has a smooth disk surface with a slit and a blade protruding from the slit (e.g., a plane or slicer equipped with a sharp blade) can be used.

From the perspective of increasing the heat conductivity of the heat conductive sheet, the angle at which the laminate is sliced is preferably 30° or less relative to the lamination direction, more preferably 15° or less relative to the lamination direction, even more preferably substantially 0° relative to the lamination direction (i.e., along the lamination direction).

From the perspective of increasing the easiness of slicing, the temperature of the laminate at the time of slicing is preferably -20°C to 40°C, more preferably 10°C to 30°C. For the same reason, the laminate is preferably sliced while applying a pressure in a direction perpendicular to the lamination direction, more preferably while applying a pressure of 0.1 MPa to 0.5 MPa in a direction perpendicular to the lamination direction. It is presumed that the particulate carbon material and the fibrous carbon material are aligned in the thickness direction in the heat conductive sheet thus obtained. Thus, the heat conductive sheet prepared through the above steps has not only heat conductivity in thickness direction but also high electrical conductivity. In the obtained heat conductive sheet, even when a carbon material with a large particle diameter was used as a material, the carbon material is crushed to have a modal diameter of 5 $\mu$m to 50 $\mu$m by mixing under stirring or disintegration. Further, the heat conductive sheet obtained through the slicing step generally has a configuration in which strips (sliced pieces of the pre-heat conductive sheet(s) which constituted the laminate) containing a resin and a carbon material having a modal diameter of 5 $\mu$m to 50 $\mu$m are joined together side-by-side.

Of note, graphene may be used as the particulate carbon material and/or fibrous carbon material that constitutes the heat conductive sheet. For use as the particulate carbon material and/or fibrous carbon material, graphene can be introduced into the heat conductive sheet using any introduction method known in the art. An exemplary introduction method is to blend graphene as it is, as a graphene dispersion liquid containing graphene dispersed in solvent, or as a graphene aggregate obtained by removing the solvent from the graphene dispersion liquid, upon preparation of a composition containing a resin and a carbon material. Any solvent can be used to prepare the graphene dispersion liquid as long as graphene can be well dispersed therein. Examples of such solvents include common polar solvents such as water, alcohols, esters such as ethyl acetate, and ketones such as methyl ethyl ketone.

Alternatively, graphene can be introduced into the heat conductive sheet by applying the graphene dispersion liquid on the pre-heat conductive sheet obtained during the manufacturing step described above.

From the perspective of increasing the manufacturing efficiency of the heat conductive sheet by increasing the easiness of the introduction operation, it is preferred to blend graphene as it is upon preparation of a composition containing a resin and a carbon material.

The graphene-containing heat conductive sheet can be optionally subjected to post-treatment to improve physical properties of graphene. Examples of post-treatment include heat treatment, light irradiation, electromagnetic wave irradiation, surface washing treatment using chemicals.

EXAMPLES

The following provides a more specific description of the present disclosure based on Examples, which however shall not be construed as limiting. In the following description, "%" and "parts" used to express quantities are by mass, unless otherwise specified.

In Examples and Comparative Examples, the modal diameter of the carbon material, the heat conductivity in thickness direction and arithmetic average roughness Ra of the heat conductive sheet, and the strength and elongation of the pre-heat conductive sheet were measured or evaluated by the methods described below. The fluororesin solution and readily dispersible aggregate used in Examples were prepared as described below.

<Modal Diameter of Carbon Material in Heat-Conductive Sheet>

3 g of the heat conductive sheet obtained in each of Examples and Comparative Examples was added to 6 g of methyl ethyl ketone and stirred for 5 minutes with a stirrer. By visual observation, it was confirmed that no sheet-like object was present in methyl ethyl ketone, and the resulting suspension was used as a test solution.

The particle diameters of the carbon material contained in each suspension were measured with a laser diffraction/scattering particle size analyzer (Model LA-960, HORIBA Scientific). A particle size distribution curve, a plot of carbon material count vs. particle diameter, was obtained and the particle diameter corresponding to the maximum in the curve was found as the number-based modal diameter of the carbon material.

<Heat Conductivity in Thickness Direction>

The heat conductive sheet was measured for thermal diffusivity $\alpha$ (m²/s) in thickness direction, specific heat at constant pressure Cp (J/g·K) and density $\rho$ (g/m³) using the methods described below. Each measurement was made at 25°C.

[Thermal Diffusivity]

Thermal diffusivity was measured using a thermal analyzer (Thermowave Analyzer TA35, BETHEL Co., Ltd.).

[Specific Heat at Constant Pressure]

Using a differential scanning calorimeter (DSC8230, Rigaku), specific heat was measured at a temperature increase rate of 10°C/min.

[Density]

Density was measured using an automated densimeter (DENSIMETER-H, TOYO SEIKI Co., Ltd.).

Using the measured values, heat conductivity $\lambda$ (W/m·K) of the heat conductive sheet in thickness direction at 25°C was obtained based on the following Equation (I):

$$\lambda = \alpha \times Cp \times \rho \dots (I)$$

<Strength and Elongation of Pre-Heat Conductive Sheet>

A test piece with dimensions of 20 mm × 80 mm was prepared by punching the pre-heat conductive sheet. The test piece was subjected to a tensile test at a tensile rate of 20 mm/min using a small tabletop tester (FGS-500TV, Nidec-Sinpo Corporation, using FGP-50 as a digital force gauge). The distance between chucks was set to 60 mm. The strength (N/mm) of the pre-heat conductive sheet was calculated by dividing the maximum strength (N) in the tensile test by the thickness (mm) of the specimen. Further, the elongation (mm) of the pre-heat conductive sheet was calculated by subtracting the length (80 mm) of the test piece before the tensile test from the maximum length of the test piece in the test.

<Arithmetic Mean Roughness Ra>

Using a surface roughness meter (SJ-201, Mitutoyo Corporation), the arithmetic mean roughness Ra was measured for both main surfaces of the heat conductive sheet prepared in each of Examples and Comparative Examples.

(Preparation of Fluororesin Solution)

30 g of fluororubber (Daiel-G 912, Daikin Industries, Ltd.) as a fluororesin was chopped with scissors into rice grain size pieces, charged into 60 g of methyl ethyl ketone, and homogeneously dissolved by stirring for 3 hours. A fluororubber solution was thus prepared in which no fluororubber was visually confirmed.

(Preparation of Readily Dispersible Aggregate of Fibrous Carbon Material)

<Preparation of Fibrous Carbon Material>

As a fibrous carbon material SGCNTs were prepared by the super growth method in accordance with the teachings of WO 2006/011655.

The SGCNTs obtained had a specific surface area of 800 $m^2/g$.

<Preparation of Readily Dispersible Aggregate of Fibrous Carbon Material>

Approximately 400 mg of the fibrous carbon material was mixed with 2L of methyl ethyl ketone and stirred with a homogenizer for 2 minutes to prepare a SGCNT/methyl ethyl ketone dispersion liquid. Using a wet jet mill (JN-20, JOKO Co., Ltd.) this dispersion liquid was passed through a 0.5 mm-diameter flow channel at a pressure of 100 MPa for 2 cycles to disperse the fibrous carbon material (aggregate of SGCNTs) in methyl ethyl ketone. In this way a carbon nanotube microdispersion liquid was prepared. The carbon nanotube microdispersion liquid had a concentration of 0.20% and a center particle diameter of 24.1 $\mu$m. The center particle diameter was measured with a laser diffraction/scattering particle size analyzer (Model LA-960, HORIBA Scientific). The obtained carbon nanotube microdispersion liquid was filtered in vacuo through filter paper (No. 5A, Kiriyama Co., Ltd.) to afford a readily dispersible aggregate of the fibrous carbon material (nonwoven fabric sheet).

(Example 1)

<Manufacture of Heat Conductive Sheet>

1 part of the readily dispersible aggregate of fibrous carbon material prepared as described above, 130 parts of expanded graphite as a particulate carbon material (EC-50, Ito Graphite Co., Ltd.; number-based modal diameter (measured value): 110 $\mu$m), 80 parts (solid) of the fluororesin solution prepared as described above, and 10 parts of a phosphate flame retardant (PX-110, Daihachi Chemical Industry Co., Ltd.) were mixed in 900 parts of ethyl acetate as solvent and stirred for 180 minutes using a Hobart mixer (Model ACM-5 LVT, Kodaira Seisakusho Co., Ltd.) at a revolution number gauge of 6. The mixture obtained was defoamed under vacuum for 1 hour, thereby removing the solvent simultaneously with defoaming to prepare a composition containing the fibrous carbon material (SGCNTs), expanded graphite as the particulate carbon material, and the fluororesin. The obtained composition was charged into a disintegrator and disintegrated for 10 seconds.

Next, 5 g of the disintegrated composition was sandwiched between 50 $\mu$m-thick sandblasted PET films (protective films) and rolled under the following conditions: roll-to-roll gap = 330 $\mu$m, roll temperature = 50°C, roll linear pressure = 50 kg/cm, roll speed = 1 m/min to afford a pre-heat conductive sheet having a thickness of 0.3 mm. The strength and elongation of the pre-heat conductive sheet obtained were calculated. The results are shown in Table 1.

100 pre-heat conductive sheets were prepared and stacked on top of each other to afford a laminate having a thickness of 3 cm. The laminate was then compressed by hand pressing to ensure close contact between the sheets. After adjusting the size of the laminate to be 6 cm long, 6 cm wide and 3 cm high, using a cutter (equipped with LBB50K blade, OLFA Corporation), the laminate was sliced at a slicing rate of 2 mm/min at an angle of $\pm 3$ degrees or less with respect to the normal of the main surface of the pre-heat conductive sheet to afford a heat conductive sheet which is 6 cm long, 3 cm wide and 0.1 cm thick. The temperature of the laminate during slicing was 25°C.

The modal diameter of the carbon material in the heat conductive sheet, and the heat conductivity in thickness direction and arithmetic average roughness Ra of the heat conductive sheet were measured or calculated in accordance with the methods described above. The results are shown in Table 1.

(Example 2)

A heat conductive sheet was prepared as in Example 1 except that the stirring time in the Hobart mixer was changed to 120 minutes. The modal diameter of the carbon material in the heat conductive sheet, and the heat conductivity in thickness direction and arithmetic average roughness Ra of the heat conductive sheet were measured or calculated in accordance with the methods described above. The strength and elongation of the pre-heat conductive sheet were also calculated in accordance with the methods described above. The results are shown in Table 1.

(Example 3)

A heat conductive sheet was prepared as in Example 1 except that the stirring time in the Hobart mixer was changed to 60 minutes. The modal diameter of the carbon material in the heat conductive sheet, and the heat conductivity in thickness direction and arithmetic average roughness Ra of the heat conductive sheet were measured or calculated in accordance with the methods described above. The strength and elongation of the pre-heat conductive sheet were also calculated in accordance with the methods described above. The results are shown in Table 1.

(Comparative Example 1)

A heat conductive sheet was prepared as in Example 1 except that the stirring time in the Hobart mixer was changed to 30 minutes. The modal diameter of the carbon material in the heat conductive sheet, and the heat conductivity in thickness direction and arithmetic average roughness Ra of the heat conductive sheet were measured or calculated in accordance with the methods described above. The strength and elongation of the pre-heat conductive sheet were also calculated in accordance with the methods described above. The results are shown in Table 1.

(Comparative Example 2)

A heat conductive sheet was prepared as in Example 1 except that the stirring time in the Hobart mixer was changed to 5 minutes. The modal diameter of the carbon material in the heat conductive sheet, and the heat conductivity in thickness direction and arithmetic average roughness Ra of the heat conductive sheet were measured or calculated in accordance with the methods described above. The strength and elongation of the pre-heat conductive sheet were also calculated in accordance with the methods described above. The results are shown in Table 1.

(Comparative Example 3)

A heat conductive sheet was prepared as in Example 1 except that the stirring time in the Hobart mixer was changed to 360 minutes. The modal diameter of the carbon material in the heat conductive sheet, and the heat conductivity in thickness direction and arithmetic average roughness Ra of the heat conductive sheet were measured or calculated in accordance with the methods described above. The strength and elongation of the pre-heat conductive sheet were also calculated in accordance with the methods described above. The results are shown in Table 1.

In Table 1 below, "SGCNTs" refer to carbon nanotubes prepared by the super growth method.

## Table 1

| | Components | Types | Ex. 1 | Ex. 2 | Ex. 3 | Comp. Ex. 1 | Comp. Ex. 2 | Comp. Ex. 3 |
|---|---|---|---|---|---|---|---|---|
| Blending amount [parts by mass] | Resin | Fluororesin | 80 | 80 | 80 | 80 | 80 | 80 |
| | Additive | Phosphate flame retardant | 10 | 10 | 10 | 10 | 10 | 10 |
| | Solvent | Ethyl acetate | 900 | 900 | 900 | 900 | 900 | 900 |
| | Particulate carbon material | Expanded graphite | 130 | 130 | 130 | 130 | 130 | 130 |
| | Fibrous carbon material | SGCNTs | 1 | 1 | 1 | 1 | 1 | 1 |
| Manufacturing condition | Stirring time [min] | | 180 | 120 | 60 | 30 | 5 | 360 |
| Modal diameter of carbon | Pre-blending (as a material) [μm] | | 110 | 110 | 110 | 110 | 110 | 110 |
| | Inside heat conductive sheet [μm] | | 7.2 | 13.5 | 48.4 | 79 | 108 | 2.1 |
| Evaluations | Heat conductivity in thickness direction [W/m·K] | | 40.0 | 40.8 | 41.2 | 42.5 | 43.6 | 32.1 |
| | Arithmetic mean roughness Ra [μm] | | 11.4 | 11.3 | 12.4 | 17.7 | 17.6 | 8.4 |
| | Strength of pre-heat conductive sheet [N/mm] | | 38.0 | 33.5 | 28.7 | 20.8 | 19.5 | 40.2 |
| | Elongation of pre-heat conductive sheet [mm] | | 2.5 | 1.9 | 1.1 | 1.1 | 1.0 | 2.6 |

As evident from Table 1, the heat conductive sheets prepared in Examples 1 to 3, which comprise strips joined together side-by-side, each strip containing a resin and a carbon material having a number-based modal diameter of 5 μm to 50 μm and which have heat conductivity in thickness direction of 40 W/m·k or more, could achieve high levels of both heat conductivity and strength of the pre-heat conductive sheet at the same time compared to Comparative Examples 1 and 2 where the carbon material has a number-based modal diameter of greater than 50 μm and Comparative Example 3 where the carbon material has a number-based modal diameter of less than 5 μm and heat conductivity in thickness direction is less than 40 W/m·k. It is also evident from Table 1 that the heat conductive sheets prepared in Examples 1 to 3, where the strength of the pre-heat conductive sheet is sufficiently high, could be manufactured with high efficiency.

INDUSTRIAL APPLICABILITY

According to the present disclosure, it is possible to provide a heat conductive sheet that achieves sufficiently high levels of heat conductivity and productivity at the same time.

**Claims**

1. A method of manufacturing a heat conductive sheet comprising strips joined together side-by-side, each strip comprising a resin and a carbon material having a number-based modal diameter of 5 μm to 50 μm and comprising a particulate carbon material,

   wherein the heat conductive sheet has heat conductivity in thickness direction of 40 W/m·k or more,
   wherein the number-based modal diameter of the carbon material refers to a particle diameter corresponding to the maximum in a particle size distribution curve of the carbon material, which is a plot of carbon material count versus particle diameter, as measured for a suspension containing the carbon material using a laser diffraction/scattering particle size analyzer,
   the method comprising:

      mixing a particulate carbon material having a first particle diameter and a resin to provide a composition;
      shaping the composition into a sheet by pressure application to provide a pre-heat conductive sheet containing the particulate carbon material having a second particle diameter and the resin;
      obtaining a laminate either by laminating the pre-heat conductive sheets on top of each other or by folding or rolling the pre-heat conductive sheet; and
      slicing the laminate at an angle of 45° or less relative to the lamination direction to provide a heat conductive sheet which comprises strips joined together side-by-side, each strip comprising the carbon material having the second particle diameter and the resin,
      **characterised in that** the particulate carbon material is subjected to a particle size change as a result of being disintegrated in the pre-heat conductive sheet forming step, such that the second particle diameter is a number-based modal diameter which is 5 μm to 50 μm and is smaller than the first particle diameter.

2. The method of manufacturing a heat conductive sheet according to claim 1, wherein the carbon material further comprises a fibrous carbon material.

3. The method of manufacturing a heat conductive sheet according to claim 1 or 2, wherein at least one main surface of the heat conductive sheet has an arithmetic mean roughness Ra of 15 μm or less.

4. The method of manufacturing a heat conductive sheet according to any one of claims 1 to 3, wherein the resin is a fluororesin.

**Patentansprüche**

1. Ein Verfahren zur Herstellung einer wärmeleitfähigen Folie umfassend miteinander verbundene aufeinanderliegende Streifen, wobei jeder Streifen ein Harz und ein Kohlenstoffmaterial, welches einen zahlenbasierten Modaldurchmesser von 5 μm bis 50 μm hat und ein partikelförmiges Kohlenstoffmaterial umfasst,

   wobei die wärmeleitfähigen Folie eine Wärmeleitfähigkeit in Dickenrichtung von 40 W/m·k oder mehr aufweist,
   wobei sich der zahlenbasierte modale Durchmesser des Kohlenstoffmaterials auf einen Partikeldurchmesser bezieht, der dem Maximum in einer Partikelgrößenverteilungskurve des Kohlenstoffmaterials entspricht, bei der es sich um eine Auftragung der Kohlenstoffmaterialanzahl gegenüber dem Partikeldurchmesser handelt, gemessen für eine Suspension, die das Kohlenstoffmaterial enthält, mithilfe eines Laserdiffraktions-/Scattering-Partikelgrößenanalysators,
   das Verfahren umfassend:

      Vermischen eines partikelförmigen Kohlenstoffmaterials mit einem ersten Partikeldurchmesser mit einem Harz, um eine Zusammensetzung zu erzeugen;
      Formen der Zusammensetzung zu einer Folie mittels Druckanwendung, um eine Vorstufe der wärmeleitfähigen Folie zu erzeugen, welche das partikelförmige Kohlenstoffmaterial mit einem zweiten Partikeldurchmesser und das Harz enthält;

Herstellen eines Laminats entweder durch Laminieren der Vorstufen der wärmeleitfähigen Folie aufeinander oder durch Falten und Rollen der Vorstufe der wärmeleitfähigen Folie; und

Zerschneiden des Laminats in einem Winkel von 45° oder weniger relativ zur Laminierungsrichtung, um eine wärmeleitfähige Folie zu erzeugen, welche miteinander verbundene aufeinanderliegende Streifen umfasst, wobei jeder Streifen das Kohlenstoffmaterial mit dem zweiten Partikeldurchmesser und das Harz umfasst,

**dadurch gekennzeichnet, dass** das partikelförmige Kohlenstoffmaterial als Folge seiner Zerlegung während des Schritts der Erzeugung der Vorstufe der wärmeleitfähigen Folie eine Größenänderung erfährt, so dass der zweite Partikeldurchmesser ein zahlenbasierter Modaldurchmesser von 5 $\mu$m bis 50 $\mu$m ist und kleiner ist als der erste Partikeldurchmesser.

2. Das Verfahren zur Herstellung einer wärmeleitfähigen Folie gemäß Anspruch 1, wobei das Kohlenstoffmaterial zusätzlich ein faserförmiges Kohlenstoffmaterial umfasst.

3. Das Verfahren zur Herstellung einer wärmeleitfähigen Folie gemäß Anspruch 1 oder 2, wobei mindestens eine Hauptoberfläche der wärmeleitfähigen Folie eine arithmetische Durchschnittsrauhigkeit Ra von 15 $\mu$m oder weniger aufweist.

4. Das Verfahren zur Herstellung einer wärmeleitfähigen Folie gemäß irgendeinem der Ansprüche 1 bis 3, wobei das Harz ein Fluorharz ist.

**Revendications**

1. Procédé de fabrication d'une feuille thermoconductrice comprenant des bandes jointes ensemble côte-à-côte, chaque bande comprenant une résine et un matériau carboné ayant un diamètre modal basé sur le nombre allant de 5 $\mu$m à 50 $\mu$m et comprenant un matériau carboné particulaire,

dans lequel la feuille thermoconductrice a une conductivité thermique dans le sens de l'épaisseur de 40 W/m.k ou plus,

dans lequel le diamètre modal basé sur le nombre du matériau carboné se réfère à un diamètre de particule correspondant au maximum dans une courbe de distribution granulométrique du matériau carboné, qui est un tracé de la quantité de matériau carboné par rapport au diamètre de particule, tel que mesuré pour une suspension contenant le matériau carboné en utilisant un analyseur granulométrique à diffraction/diffusion par laser, le procédé comprenant :

le mélange d'un matériau carboné particulaire ayant un premier diamètre de particule et d'une résine pour fournir une composition ;

la mise en forme de la composition en une feuille par application de pression pour fournir une pré-feuille thermoconductrice contenant le matériau carboné particulaire ayant un deuxième diamètre de particule et la résine ;

l'obtention d'un stratifié soit en stratifiant les pré-feuilles thermoconductrices les unes au-dessus des autres, soit en pliant ou en enroulant la pré-feuille thermoconductrice ;
et

le découpage en tranches du stratifié selon un angle de 45° ou moins par rapport à la direction de stratification pour fournir une feuille thermoconductrice qui comprend des bandes jointes ensemble côte-à-côte, chaque bande comprenant le matériau carboné ayant le deuxième diamètre de particule et la résine,

**caractérisé en ce que**

le matériau carboné particulaire est soumis à un changement de taille de particule après avoir été désintégré dans l'étape de formage de la pré-feuille thermoconductrice, de sorte que le deuxième diamètre de particule est un diamètre modal basé sur le nombre qui va de 5 $\mu$m à 50 $\mu$m et est inférieur au premier diamètre de particule.

2. Procédé de fabrication d'une feuille thermoconductrice selon la revendication 1, dans lequel le matériau carboné comprend en outre un matériau carboné fibreux.

**3.** Procédé de fabrication d'une feuille thermoconductrice selon la revendication 1 ou 2, dans lequel au moins une surface principale de la feuille thermoconductrice a une rugosité moyenne arithmétique Ra de 15 $\mu$m ou moins.

**4.** Procédé de fabrication d'une feuille thermoconductrice selon l'une quelconque des revendications 1 à 3, dans lequel la résine est une fluororésine.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008053843 A
- US 20140293626 A1
- JP 2013058701 A
- US 20130065016 A1
- WO 2006011655 A